Europäisches Patentamt

European Patent Office

Office européen des brevets

(19)

(11) Veröffentlichungsnummer: **0 104 443**
**B1**

# (12) EUROPÄISCHE PATENTSCHRIFT

(45) Veröffentlichungstag der Patentschrift:
30.04.86

(21) Anmeldenummer: 83108343.1

(22) Anmeldetag: 24.08.83

(51) Int. Cl.⁴: **H 04 B 14/02, G 11 C 19/00**

(54) Verfahren und Schaltungsanordnung zur Umcodierung von Codewörtern.

(30) Priorität: 01.09.82 DE 3232548

(43) Veröffentlichungstag der Anmeldung:
04.04.84 Patentblatt 84/14

(45) Bekanntmachung des Hinweises auf die Patenterteilung:
30.04.86 Patentblatt 86/18

(84) Benannte Vertragsstaaten:
AT BE CH DE FR GB IT LI NL SE

(56) Entgegenhaltungen:
DE - A - 1 922 935
DE - A - 2 621 882
DE - B - 1 227 063
FR - A - 2 312 883
US - A - 3 796 830

(73) Patentinhaber: **Siemens Aktiengesellschaft, Berlin und München Wittelsbacherplatz 2, D-8000 München 2 (DE)**

(72) Erfinder: **von Sichart, Frithjof, Dr.,
Karl-Theodor-Strasse 72, D-8000 München 40 (DE)**
Erfinder: **Wiedeburg, Klaus, Dr., Veilchenstrasse 7,
D-8039 Puchheim (DE)**

EP 0 104 443 B1

LIBER, STOCKHOLM 1986

## Beschreibung

Die Erfindung bezieht sich auf eine Umcodierung von Codewörtern eines Code mit m-stelligen Codewörtern in die entsprechenden Codewörter eines anderen Code mit ebenfalls m-stelligen Codewörtern. Eine ähnliche Umcodierung = um zwecke der Dämpfung digitaler signale ist aus der FR-A- 2312883 bekannt.

In der Digitalkommunikationstechnik und ebenso auch in der Datenverarbeitungstechnik werden Informationen zum Zwecke der Weitergabe oder auch Verarbeitung durch ein sich aus Folgen von sog. Codewörtern zusammensetzendes Digitalsignal dargestellt, wobei die Codewörter ggf. aus einem zugrundeliegenden Analogsignal durch ständig wiederholte Abtastung, Quantisierung und Codierung gewonnen sein können und dann dem jeweiligen Analogsignal-Abtastwert entsprechen.

Für den Zusammenhang zwischen den Analogsignalwerten eines Fernsprech-Analogsignals und den Codewörtern eines entsprechenden Fernsprech-Digitalsignals gibt es zwei CCITT-Empfehlungen, die üblicherweise als A-law und μ-law bezeichnet werden und die beide eine logarithmische Quantisierungsintervall-/Analogsignalwert

Kompandierungskennlinie jeweils durch eine segmentweise lineare Knickkennlinie annähern. Obwohl sich dabei die dem sog. A-law folgende Knickkennlinie in einem Digital/Analog-Wandler in schaltungstechnisch besonders günstiger Weise mit Hilfe eines mit einem Konstantstrom gespeisten sog. R-2R-Netzwerks realisieren läßt, wird in manchen Ländern doch der weniger einfach zu realisierenden μ-Kennlinie der Vorzug gegeben. Dies hat zur Folge, daß ggf. für an sich gleiche, aber in unterschiedlichen Ländern zum Einsatz kommende Kommunikationsgeräte unterschiedliche Codierer/Decodierer (Codec) vorgesehen werden müssen, was eine für eine Großintegration unerwünschte Reduktion der jeweils benötigten Stückzahlen mit sich bringt, oder aber daß man, von einem einheitlichen Codec ausgehend, eine zusätzliche Umcodierung der Ausgangs- bzw. Eingangsbits beispielsweise mittels eines Rechenwerkes bewirken muß.

Der Erfindung liegt die Aufgabe zugrunde, derartige Aufwandserhöhungen zu vermeiden und stattdessen einen anderen Weg zu einer Umcodierung der eingangs umrissenen Art aufzuzeigen.

Die Erfindung betrifft ein Verfahren zur Umcodierung von Codewörtern eines Code mit m-stelligen Codewörtern in die entsprechenden Codewörter eines anderen Code mit ebenfalls m-stelligen Codewörtern; dieses Verfahren ist erfindungsgemäß dadurch gekennzeichnet, daß die einzelnen Bits des umzucodierenden Codewortes während dessen serieller Eingabe in ein m-stelliges Schieberegister oder während der seriellen Ausgabe deraus von Registerstufe zu Registerstufe jeweils über eine Weitergabeschaltung nach Maßgabe der Übereinstimmung bzw. Nichtübereinstimmung der einzelnen Bits von umzucodierendem Codewort des einen Code und entsprechendem Codewort des anderen Code in der Weise nichtnegiert bzw. negiert weitergegeben werden, daß die durchlaufenden Bits jeweils vor und nach einer mit ihrer Position innerhalb des Schieberegisters der Position nichtübereinstimmender Bits innerhalb der beiden Codewörter entsprechenden Registerstufe eine Negation erfahren.

Die Erfindung, die nicht an die Umcodierung von A-law-Codewörtern in μ-law-Codewörter und umgekehrt gebunden ist, sondern auch bei einer anderen bei gleichbleibender Bitrate vor sich gehenden Umcodierung, beispielsweise bei der im Zuge einer A-law-Codierung erforderlichen Inversion jedes zweiten Bits oder auch bei einem sog. Scrambeln Anwendung finden kann, ermöglicht eine bei gleichbleibender Bitrate vor sich gehende Umcodierung mit sehr geringem schaltungstechnischen Aufwand, insbesondere auch insofern, als in Weiterbildung der Erfindung etwa am Anfang oder Ende eines Übertragungsweges beispielsweise zur Pufferung und/oder zur Parallel/ Serien- bzw. Serien/Parallel-Umsetzung ohnehin vorhandene Schieberegister lediglich mit entsprechenden Weitergabeschaltungen ergänzt zu werden brauchen und dann für die Umcodierung gemäß der Erfindung mitausgenutzt werden können; dabei können in Nachrichten seriell sendenden und empfangenden Geräten, die ein und dasselbe Schieberegister zum Senden und Empfangen verwenden, die den Schieberegisterstufen zugehörigen Weitergabeschaltungen ebenfalls doppelt ausgenutzt werden.

Anhand der Zeichnung sei die Erfindung noch näher erläutert. Dabei zeigt

FIG 1 schematisch ein Ausführungsbeispiel einer Schaltungsanordnung zur Umcodierung gemäß der Erfindung;

FIG 2 zeigt weitere schaltungstechnische Einzelheiten einer solchen Schaltungsanordnung.

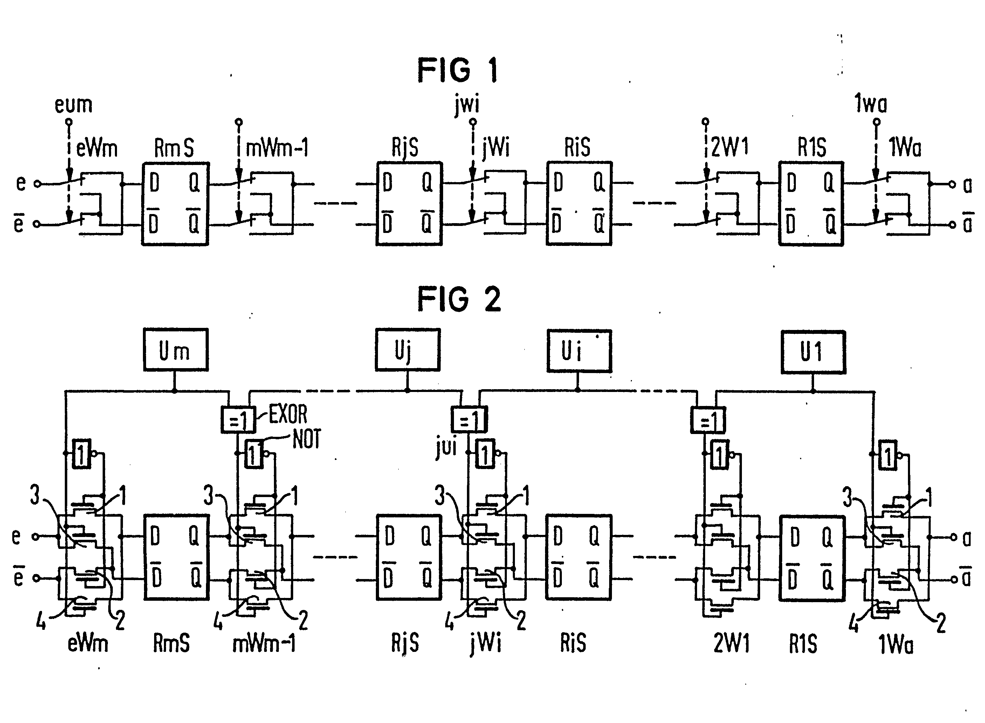

In FIG 1 ist schematisch in einem zum Verständnis der Erfindung erforderlichen Umfang ein Ausführungsbeispiel einer Schaltungsanordnung zur Umcodierung von Codewörtern eines Code mit m-stelligen Codewörtern in die entsprechenden Codewörter eines anderen Code mit ebenfalls m-stelligen Codewörtern gemäß der Erfindung dargestellt. In dieser Schaltungsanordnung ist ein m-stelliges Schieberegister mit jeweils einen Setzeingang D und einen Rücksetzeingang $\bar{D}$ sowie neben einem Ausgang Q einen Komplementärausgang $\bar{Q}$ aufweisenden Registerstufen RmS,...,RjS, RiS,..., R1S vorgesehen. Vor und hinter den Registerstufen liegen Weitergabeschaltungen eWm, mWm-1,...,jWi,...,2W1, 1Wa. Dabei ist nach Maßgabe eines am Steuereingang eum der Weitergabeschaltung eWm anliegenden Steuerbits der Eingang e des Schieberegisters mit dem Setzeingang D oder dem Rücksetzeingang $\bar{D}$ der Registerstufe RmS und

der Komplemtäreingang ē des Schieberegisters mit dem Rücksetzeingang D̄ oder dem Setzeingang D der Registerstufe RiS verbunden. Nach Maßgabe der an den nachfolgenden Weitergabeschaltungen ..., jWi,... anliegenden Steuerbits ist jeweils der Ausgang einer jeweils vorangehenden Registerstufe mit dei Setzeingang oder dem Rücksetzeingang der jeweils nachfolgenden Registerstufe und jeweils der Komplementärausgang der jeweils vorangehenden Registerstufe mit dem Rücksetzeingang oder dem Setzeingang der jeweils nachfolgenden Registerstufe verbunden; so ist beispielsweise nach Maßgabe des am Steuereingang jwi der Weitergabeschaltung jWi anliegenden Steuerbits der Ausgang Q der vorangehenden Registerstufe RjS mit dem Setzeingang D oder dem Rücksetzeingang D̄ der nachfolgenden Registerstufe RiS verbunden und der Komplementärausgang Q̄ der Registerstufe RjS mit dem Rücksetzeingang D̄ oder dem Setzeingang D̄ der Registerstufe RiS. Schließlich ist nach Maßgabe des am Steuereingang 1Wa der Weitergabeschaltung 1Wa anliegenden Steuerbits der Ausgang Q der Registerstufe R1S mit dem Ausgang a oder dem Komplementärausgang ā des Schieberegisters verbunden und der Komplementärausgang Q̄ der Registerstufe R1S mit dem Komplementärausgang ā oder dem Ausgang a des Schieberegisters.

Die Negation von Bits eines umzucodierenden m-Bit-Codewortes und damit dessen Umkodierung geschieht nun in der Weise, daß bei der seriellen Eingabe des umzucodierenden Codewortes jeweils vor und nach derjenigen Registerstufe, deren Position im Schieberegister der Position des betreffenden Bits im Codewort entspricht, durch Umschalten der betreffenden, an ihren Steuereingängen dazu mit entsprechenden Steuerbits beaufschlagten Weitergabeschaltungen die jeweils durchlaufenden Bits des Codewortes negiert werden. Jedes tatsächlich zu negierende Bit erfährt dabei gerade eine Negation (bzw. eine ungeradzahlige Anzahl von Negationen), während jedes nicht zu negierende Bit null oder zwei Negationen (bzw. eine geradzahlige Anzahl von Negationen) erfährt und somit im Ergebnis unverändert bleibt. Sobald das letzte Bit des umzucodierenden Codewortes in das Schieberegister RmS,..., RjS, RiS,..., R1S eingegeben worden ist, steht somit im Schieberegister anstelle des umzucodierenden Codewortes bereits das umcodierte Codewort, das dann beispielsweise parallel oder auch - bei nunmehr aber leitungskreuzungsfreien und damit keine Negation bewirkenden Weitergabeschaltungen - seriell ausgegeben werden kann.

Alternativ dazu ist es auch möglich, das umzucodierende Codewort parallel oder bei leitungskreuzungsfreien und damit keine Negation bewirkenden Weitergabeschaltungen seriell in das Schieberegister RmS,...,RjS,

RiS,...,R1S einzugeben und die Umcodierung erst bei der seriellen Codewortausgabe vorzunehmen, indem dann bei der Codewortausgabe durch entsprechendes Umschalten der Weitergabeschaltungen bewirkt wird, daß wiederum nach Maßgabe der Übereinstimmung bzw. Nichtübereinstimmung der einzelnen Bits von umzucodierendem Codewort des einen Code und enteprechendem Codewort des anderen Code in der Weise nichtnegiert bzw. negiert weitergegeben werden, daß die durchlaufenden Bits jeweils vor und nach einer Registerstufe, deren Position innerhalb des Schieberegisters der Position nichtübereinstimmender Bits innerhalb der beiden Codewörter entspricht,eine Negation erfahren.

Die Weitergabeschaltungen können, wie dies in weiteren Einzelheiten aus FIG 2 ersichtlich wird, jeweils durch eine X-Schaltung mit vier Transistorschaltern 1, 2, 3, 4 mit MOS-Transistoren gebildet sein, in der jeweils zwei jeweils an getrennten Eingangsklemmen und getrennten Ausgangsklemmen der X-Schaltung angeschlossene Transistorschalter mit dem jeweiligen Steuerbit und die jeweils anderen beiden Transistorschalter mit dem negierten Steuerbit beaufschlagt werden. In FIG 2 ist dazu angedeutet, daß die Steuerelektroden der beiden gewissermaßen gekreuzt durchschaltenden Transistorschalter 3 und 4 direkt an die jeweilige, das betreffende Steuerbit führende Steuerleitung angeschlossen ist, während die Steuerelektroden der beiden jeweils gewissermaßen ungekreuzt durchschaltenden Transistorschalter 1 und 2 über ein NICHT-Glied NOT an die jeweilige, das betreffende Steuerbit führende Steuerleitung angeschlossen sind.

In der Schaltungsanordnung gemäß FIG 2 wird die die Umcodierung steuernde Steuerinformation in Form eines Steuerbytes in Paralleldarstellung an die Steuerleitungen angelegt, wobei die einzelnen Steuerbits von den einzelnen Zellen eines Steuerinformationsregisters Um,..., Uj, Ui..., U1 abgegeben werden. Dabei kann durch Eintragen eines entsprechenden Steuerbytes jede beliebige Umcodierung von m-stelligen Codewörtern eines Code in die entsprechenden m-stelligen Codewörter eines anderen Code bewirkt werden.

Alternativ dazu - und ohne daß dies in der Zeichnung dargestellt ist - ist es aber auch möglich, eine einzige Steuerbitleitung derart jeweils direkt oder über einen Negator mit den Steuerelektroden der Transistorschalter der einzelnen Weitergabeschaltungen zu verbinden, daß die gewünschte Umcodierung beim Schieben des Inhalts des Schieberegisters RmS,...,RjS, RiS,...,R1S erfolgt.

Wird, wie aus FIG 2 ersichtlich, die Steuerinformation in Form eines Steuerbytes in Paralleldarstellung bereitgestellt, so ist es, wie dies ebenfalls aus FIG 2 ersichtlich ist, auch möglich, den Aufwand für Doppelnegationen zwischen benachbarten Schieberegisterstufen dadurch zu vermeiden, daß die das Steuerbit einer zwischen zwei Registerstufen, beispielsweise den Registerstufen RjS und RiS, liegenden Weitergabeschaltung, im Beispiel der Weitergabeschaltung jWi, führende Steuerleitung jui die Ausgangsleitung eines EXCLUSIV-ODER-Gliedes EXOR ist, dessen beide Eingänge mit denjenigen beiden Steuerbits beaufschlagt sind, deren Positionen innerhalb des Steuerbytes den Positionen der beiden Registerstufen (RjS und RiS) innerhalb des Schieberegisters entsprechen.

Sollen nun beispielsweise alle Bits jedes Codeworts mit Ausnahme des jeweils ersten Bits negiert werden, wie dies z.B. bei einer A-law/µ-law-Umcodierung der Fall wäre, so wird bei der seriellen Eingabe oder Ausgabe des dabei umcodierten Codeworts in das bzw. aus dem Schieberegister RmS,...,RjS, RiS,..., R1S von allen Steuerinformationszelle; Um,...,Uj,Ui... - mit Ausnahme der ein Steuerbit "0" bereitstellenden Steuerinformationszelle U1 - ein Steuerbit "1" bereitgestellt. Die Steuerbits werden in den EXCLUSIV-ODER-Gliedern EXOR paarweise verknüpft, so daß bei den mit ihren Steuerleitungen an die EXCLUSIV-ODER-Glieder EXOR angeschlossenen Weitergabeschaltungen mWm-1,..., jWi,..., 2W1 die eine gekreuzte Durchschaltung bewirkenden Transistorschalter 3 und 4 lediglich der Weitergabeschaltung 2W1 in den Leitzustand gesteuert werden, während bei den übrigen Weitergabeschaltungen mWm-1,...,jWi,... die Transistorschalter 3 und 4 im Sperrzustand verbleiben und die Transistorschalter 1 und 2 dort jeweils eine ungekreuzte Durchschaltung bewirken. Außerdem werden durch das von der Steuerinformationszelle Um abgegebene Steuerbit "1" in der Weitergabeschaltung eWm die eine gekreuzte Durchschaltung bewirkenden Transistorschalter 3 und 4 in den Leitzustand gesteuert; das von der Steuerinformationszelle U1 abgegebene Steuerbit "0" hält schließlich in der Weitergabeschaltung 1Wa die eine ungekreuzte Durchschaltung bewirkenden Transistorschalter 1 und 2 im Leitzustand. Damit ergibt sich, daß von allen Bits eines über die Eingangsklemmen e und ē seriell in das Schieberegister RmS,...,RjS, RiS,...,R1S eingegebenen Codewortes lediglich das bis zur Schieberegisterstufe R1S durchlaufende erste Bit eine zweimalige Negation erfährt, nämlich in den Weitergabeschaltungen eWm und 2W1, während die nachfolgenden Bits jeweils nur eine Negation erfahren, nämlich in der Weitergabeschaltung eWm. Damit steht dann nach der vollständigen seriellen Eingabe des umzucodierenden Codewortes in das Schieberegister in diesem gerade das umcodierte Codewort, das dann parallel oder - ohne weitere Negationen - auch seriell aus dem Schieberegister ausgelesen werden kann.

**Patentansprüche**

1. Verfahren zur Umcodierung von Codewörtern eines Code mit m-stelligen Codewörtern in die entsprechenden Codewörter eines anderen Code mit ebenfalls m-stelligen Codewörtern, dadurch gekennzeichnet, daß die einzelnen Bits des umzucodierenden Codewortes während dessen serieller Eingabe in ein m-stelliges Schieberegister oder während der seriellen Ausgabe daraus von Registerstufe zu Registerstufe jeweils über eine Weitergabeschaltung nach Maßgabe der Übereinstimmung oder Nichtüberein-. stimmung der einzelnen Bits von umzucodierendem Codewort des einen Code und entsprechendem Codewort des anderen Code in der Weise nichtnegiert bzw. negiert weitergegeben werden, daß die durchlaufenden Bits jeweils sowohl vor als auch nach einer mit ihrer Position innerhalb des Schieberegisters der Position nichtübereinstimmender Bits innerhalb der beiden Codewörter entsprechenden Registerstufe eine Negation erfahren.

2. Schaltungsanordnung zur Durchführung des Verfahrens nach Anspruch 1, dadurch gekennzeichnet, daß in einem mit jeweils einen Setzeingang (D) und einen Rücksetzeingang (D̄) sowie einen Ausgang (Q) und einen Komplementärausgang (Q̄) aufweisenden Registerstufen (RmS,...,RjS, RiS,...,R1S) und mit vor und hinter den Registerstufen (RmS,...,RjS,RiS,...,R1S) liegenden Weitergabeschaltungen (eWm,...,jWi,...,1Wa) aufgebauten, nichtrückgekoppelten Schieberegister nach Maßgabe einer an den Weitergabeschaltungen (eWm,...,jWi,...,1Wa) anliegenden Steuerinformation jeweils der Ausgang (Q) einer jeweils vorangehenden Registerstufe (RjS,R1S) bzw. der Eingang (e) des Schieberegisters mit dem Setzeingang (D) oder dem Rücksetzeingang (D̄) der jeweils nachfolgenden Registerstufe (RiS; Rms) bzw. mit dem Ausgang (a) oder dem Komplementärausgang (ā) des Schieberegisters verbunden ist und jeweils der Komplementärausgang (Q̄) der jeweils vorangehenden Registerstufe (RjS; R1S) bzw. der Komplementäreingang (ē) des Schieberegisters mit dem Rücksetzeingang (D̄) oder dem Setzeingang (D) der jeweils nachfolgenden Registerstufe (RiS; RmS) bzw. mit dem Komplementärausgang (ā) oder dem Ausgang (a) des Schieberegisters verbunden ist.

3. Schaltungsanordnung nach Anspruch 2, dadurch gekennzeichnet, daß die Weitergabeschaltungen (jWi) jeweils durch eine X-Schaltung mit vier Transistorschaltern (1, 2, 3, 4) gebildet sind, in der jeweils zwei jeweils an getrennten Eingangsklemmen und getrennten Ausgangsklemmen der X-Schaltung angeschlossene Transistorschalter mit dem jeweiligen Steuerbit und die beiden jeweils anderen Transistorschalter mit dem negierten Steuerbit beaufschlagt sind.

4. Schaltungsanordnung nach Anspruch 3, dadurch gekennzeichnet, daß die das Steuerbit einer zwischen zwei Registerstufen (RjS, RiS) liegenden Weitergabeschaltung (jWi) führende Leitung die Ausgangsleitung eines EXCLUSIV-ODER-Gliedes ist, dessen beide Eingänge mit den beiden in ihren Positionen innerhalb der Steuerinformation den Positionen der beiden Registerstufen (RjS, RiS) innerhalb des Schieberegisters entsprechenden Steuerbits beaufschlagt sind.

**Claims**

1. A method of recoding code words or a code comprising m-digit code words into the corresponding code words or a different code likewise comprising m-digit code words, <u>characterised in</u> that during the serial input of the code word which is to be recoded into an m-position shift register or during the serial output thereof from the m-position shift register, the individual bits of this code word are forwarded from register stage to register stage in non-negated or negated form depending upon the identity or non-identity of the individual bits of the code word of the first code which is to be recoded end of the corresponding code word of the other code, in that the throughgoing bits each experience a negation both before and following a register stage whose position within the shift register corresponds to the position of non-identical bits within the two code words.

2. A circuit arrangement for the implementation of the method claimed in claim 1, <u>characterised in</u> that in a shift register which has no feedback and which is constructed from register stages (RmS,...,RjS, RiS,...,R1S) which each comprise a set input (D) and a reset input (D̄) and likewise an output (Q) and a complementary output (Q̄), and from forwarding circuits (eWm,...,jWi...,1Wa) which are located before and following the register stages (RmS,...,RjS, RiS,...,R1S), in accordance with an item of control information occurring in the forwarding circuits (eWm,...,jWi,...,1Wa), the output (Q) of a preceding register stage (RjS, R1S) or the input (e) of the shift register is connected to the set input (D) or the reset input (D̄) of the following register stage (RiS; Rms) or to the output (a) or complementary output (ā) of the shift register, and that the complementary output (Q̄) of the preceding register stage (RjS; R1S) or the complementary input (ē) of the shift register is connected to the reset input (D̄) or the set input (D) of the following register stage (RiS; RmS) or to the complementary output (ā) or output (a) of the shift register.

3. A circuit arrangement as claimed in claim 2, <u>characterised in</u> that the forwarding circuits (jWi) each comprise an X-circuit which is composed of four transistor switches (1,2,3,4) and in which two transistor switches, which are each connected to separate input terminals and separate output terminals or the X-circuit, are each fed with the control bit, whereas the two other transistor switches are each fed with the negated control bit.

4. A circuit arrangement as claimed in claim 3, <u>characterised in</u> that the line which carries the control bit to a forwarding circuit (jWi) located between two register stages (RjS, RiS) is the output line or an EXCLUSIVE-OR-gate whose two inputs are supplied with the two control bits whose positions within the control information correspond to the positions of the two register stages (RjS, RiS) within a shift register.

**Revendications**

1. Procédé pour le transcodage de mots d'un code comportant des mots de code à m positions en les mots correspondants d'un autre code comportant également des mots de code à m positions, caractérisé par le fait que les différents bits du mot de code devant être transcodé sont retransmis avec ou sans inversion, pendant leur introduction séquentielle dans un registre à décalage à m positions ou bien pendant la sortie séquentielle hors de ce registre, d'un étage à l'autre du registre, respectivement par l'intermédiaire d'un circuit de retransmission en fonction de la concordance ou de la non concorance des différents bits du mot devant être transcodé d'un code et du mot correspondant de l'autre code, de telle sorte que les bits parcourant subissent une inversion aussi bien en amont qu'en aval d'un étage du registre à décalage, dont la position à l'intérieur de ce dernier correspond à la position de bits non concordants à l'intérieur des deux mots de code.

2. Montage pour la mise en oeuvre du procédé suivant la revendication 1, caractérisé par le fait que dans un registre à décalage, qui ne comporte pas de couplage par réaction et est constitué par des étages (Rms,..., Rjs, Ris,..., RIS), possédant chacun une entrée de positionnement (D) et une entrée de remise à l'état initial (D̄) ainsi qu'une sortie (Q) et une sortie complémentaire (Q̄), et par des circuits de retransmission (eWm, ..., jWi,..., 1Wa) situés en amont et en aval des étages (RmS,..., Rjs, Ris,..., RIS) du registre, respectivement à la sortie (Q) d'un étage respectivement précédent (RjS, RIS) du registre ou l'entrée (e) du registre à décalage est reliée, en fonction d'uné information de commande appliquée aux circuits de retransmission (eWm,... .., JWi, ..., 1Wa), à l'entrée de positionnement (D) ou à l'entrée de remise à l'état initial (D̄) de l'étage respectivement suivant (RiS, RmS) du registre ou à la sortie (a) ou à la sortie complémentaire (ā) du registre à décalage et respectivement la sortie complémentaire (Q̄) de l'étage respectivement précédent (RjS; RIS) du registre ou l'entrée complémentaire (ē) du registre à décalage est reliée à l'entrée de remise à l'état initial (D̄) ou à l'entrée de positionnement (D) de l'étage respectivement suivant (RiS; RmS) du registre ou à la sortie complémentaire (ā) ou à la sortie (a) du registre à décalage.

3. Montage suivant la revendication 2, caractérisé par le fait que les circuits dé retransmission (jWi) sont formés respectivement par un circuit en croix comportant quatre commutateurs à transistors (1, 2, 3, 4) dans lequel respectivement lés commutateurs à transistors, qui sont raccordés respectivement à des bornes séparées d'entrée et à des bornes séparées de sortie du circuit croisé sont chargés par le bit respectif de commande et les deux autres commutatéurs à transistors respectifs sont chargés par le bit de commande inversé.

4. Montage suivant la revendication 3, caractérisé par le fait que la ligne amenant le bit de commande à un circuit de retransmission (jWi) monté entre deui étages (RjS, RiS) du registre, est la ligne de sortie d'un circuit OU-EXCLUSIF, dont les deux entrées sont chargées par les deux bits de commande, dont les positions à l'intérieur de l'information de commande correspondent aux positions des deux étages (RjS, RiS) à l'intérieur du registre à décalage.

# FIG 1

# FIG 2

0 104 443